(19) Europäisches Patentamt
European Patent Office
Office européen des brevets

(11) EP 0 453 998 B1

(12) EUROPEAN PATENT SPECIFICATION

(45) Date of publication and mention
of the grant of the patent:
**02.07.1997 Bulletin 1997/27**

(51) Int Cl.⁶: **H01L 27/108**, H01L 21/8242

(21) Application number: **91106366.7**

(22) Date of filing: **19.04.1991**

(54) **Semiconductor memory device having a bit line constituted by a semiconductor layer**

Halbleiterspeicherbauteil mit Bitleitung, welche aus einer Halbleiterschicht besteht

Dispositif semi-conducteur à mémoire ayant une ligne de bit constituée d'une couche semi-conductrice

(84) Designated Contracting States:
**DE FR GB**

(30) Priority: **21.04.1990 JP 105911/90**

(43) Date of publication of application:
**30.10.1991 Bulletin 1991/44**

(73) Proprietor: **KABUSHIKI KAISHA TOSHIBA**
**Kawasaki-shi, Kanagawa-ken 210 (JP)**

(72) Inventors:
• **Kumagai, Jumpei, c/o Intellectual Property Div.**
**Minato-ku, Tokyo 105 (JP)**
• **Sawada, Shizuo, c/o Intellectual Property Div.**
**Minato-ku, Tokyo 105 (JP)**

(74) Representative: **Lehn, Werner, Dipl.-Ing. et al**
**Hoffmann, Eitle & Partner,**
**Patentanwälte,**
**Postfach 81 04 20**
**81904 München (DE)**

(56) References cited:
EP-A- 0 042 084          EP-A- 0 348 046
US-A- 4 829 017          US-A- 4 845 537

• IBM TECHNICAL DISCLOSURE BULLETIN, vol. 23, no. 9, February 1981, pages 4052-4053, New York, US; D.M. KENNEY : 'Reduced bit line capacitance in VMOS devices'
• PATENT ABSTRACTS OF JAPAN, vol. 13, no. 594 (E-867)[3942], 27th December 1989; & JP-A-1 248 557
• PATENT ABSTRACTS OF JAPAN, vol. 13, no. 493 (E-842)[3814], 8th November 1989; & JP-A-1 198 065
• PATENT ABSTRACTS OF JAPAN, vol. 14, no. 168 (E-912)[4111], 30th March 1990; & JP-A-2 026 066

## Description

The present invention relates to a semiconductor memory device. More particularly, this invention pertains to a semiconductor memory device in which a bit line formed in a memory cell is constituted by a semiconductor layer.

The following has been presented as a semiconductor memory device having memory cells with a bit line formed by a semiconductor layer:

A TRENCH TRANSISTOR CROSS-POINT DRAM CELL W.F. RICHARDSON ET AL. IEDM85. p714-p717.

The disclosed DRAM cell has a trench on a silicon substrate, with a storage node formed in the trench. A storage dielectric is formed between the storage node and the substrate. Part of the storage node is connected to the substrate. An insulating film is formed on the exposed face of the storage node to isolate the storage node from a word line. The word line, which is so formed as to come into the trench, serves as a gate to from a channel in the substrate along the side wall of the trench. Further, an n+ type diffused bit line is formed in the direction normal to the plane containing the word line.

With the above structure, as each memory cell is formed at the cross point between the word line and bit line, it is easy to provide high integration of memory cells.

Because of the bit line formed by the n+ type diffusion layer, however, the following problems would arise:

(1) As the bit line is isolated from the substrate by a pn junction, the capacity of the bit line is large or the capacity of the pn junction is large. This results particularly in a reduction in the speed of an electrical signal traveling through the bit line, slowing the operational speed. Further, the large bit line capacity drops the potential of a minute electric signal flowing across the bit line. This conventiqnal DRAM is not suitable for larger scale integration (16M, 64M, 256M, 1G, ....).

(2) Since the isolation of the bit line from the substrate is realized by the pn junction, there is a large junction leak current flowing from the bit line to the substrate. That is, the pn junction reverse current is large. Accordingly, the potential of a minute electric signal flowing across the bit line is likely to change, reducing the reliability, and the conventional DRAM is not suitable for larger scale integration which will surely be realized.

(3) Due to the isolation of the bit line from the substrate by the pn junction, this DRAM has a low resistiveness to a soft error. There is a high probability of α rays or the like entering particularly the bit line or a high probability of catching carriers ionized by α rays or the like, so that noise is likely to appear the bit line. In addition, the carriers entering the bit line may easily cause a malfunction (soft error), thus reducing the operational reliability.

These problems are addressed in JP1-198065 and JP1-248557, and the preamble of claim 1 reflects the disclosure of these documents. A pillar type DRAM having different intervals between pillars in word and bit line directions is known from EP-A-0 348 046.

It is therefore an object of the present invention to provide an improved method of manufacture.

According to the present invention there is provided a method as set out in claim 1.

This invention can be more fully understood from the following detailed description when taken in conjunction with the accompanying drawings, in which:

Fig. 1 is a schematic pattern plan view illustrating DRAM cells (four cells) according to the first embodiment of the present invention;
Fig. 2 is a cross section taken along the line 2-2 in Fig. 1;
Fig. 3 is a cross section taken along the line 3-3 in Fig. 1;
Fig. 4 is a diagram of an equivalent circuit of the DRAM cells according to the first embodiment;
Figs. 5A to 5L are cross sections of the step-by-step illustration of processes for fabricating the DRAM cell according to the first embodiment;
Figs. 6A and 6B are pattern plan views the step-by-step illustration of the first modification of the fabricating method;
Fig. 7A is a cross section taken along the line 7A-7A in Fig. 6A;
Fig. 7B is a cross section taken along the line 7B-7B in Fig. 6B;
Fig. 8A is a cross section taken along the line 8A-8A in Fig. 6A;
Fig. 8B is a cross section taken along the line 8B-8B in Fig. 6B;
Figs. 9A and 9B are pattern plan views the step-by-step illustration of the second modification of the fabricating method;
Fig. 10A is a cross section taken along the line 10A-10A in Fig. 9A;
Fig. 10B is a cross section taken along the line 10B-10B in Fig. 9B;
Fig. 11A is a cross section taken along the line 11A-11A in Fig. 9A;
Fig. 11B is a cross section taken along the line 11B-11B in Fig. 9B;
Figs. 12A and 12B are pattern plan views the step-by-step illustration of the third modification of the fabricating method;
Figs. 13A to 13D are pattern plan views the step-by-step illustration of the fourth modification of the fabricating method;
Figs. 14A to 14D are cross sections respectively taken along the lines 14A-14A to 14D-14D in Figs. 13A to 13D;

Preferred embodiments of the present invention will now be described referring to the accompanying drawings.

First Embodiment

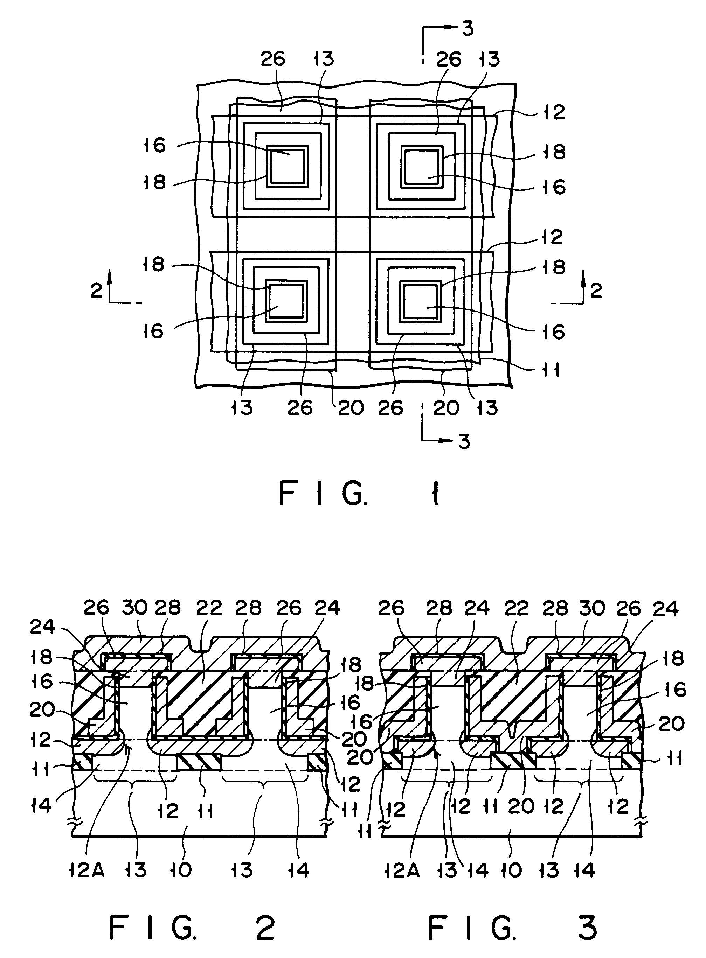

Fig. 1 is a schematic pattern plan view illustrating DRAM cells (four cells) according to the first embodiment of the present invention. Fig. 2 is a cross section taken along the line 2-2 in Fig. 1. Fig. 3 is a cross section taken along the line 3-3 in Fig. 1.

As shown in Figs. 1 to 3, the DRAM cell embodying the present invention has the following structure.

A bit line is formed on, for example, a p type silicon substrate 10 through an insulating film 11 formed by, for example, a silicon oxide film. The bit line is constituted by an n type semiconductor layer 12 isolated in the bit-line forming direction. In some places of the insulating film 11 are formed openings 13 through which the p type substrate 10 is exposed. A p type silicon epitaxial layer 14 connected via the opening 13 to the p type substrate 10 is formed on the insulating film 11. The n type semiconductor layer 12 constituting the bit line is formed in this p type epitaxial layer 14. A p type silicon columnar region 16, which communicates with the p type substrate 10, is formed on that p type epitaxial layer 14 which corresponds to the opening 13. In the columnar region 16, an n type diffusion layer 12A is formed by an n type impurity diffused from the n type semiconductor layer 12. A gate insulating film 18 comprising, for example, a silicon oxide film or the like, is formed around the p type columnar region 16. On this gate insulating film 18 is formed an n type polysilicon layer 20 which constitutes a word line. The polysilicon layer 20 is formed, isolated in the direction normal to the plane containing the bit line. The word line 20 is isolated by an interlayer insulating film 22. This interlayer insulating film 22 also isolates the bit line (n type semiconductor layer 12) at some locations (not shown). An n type diffusion layer 24 is formed at the tip portion of the p type columnar region 16. An n type polysilicon layer 26 is formed on the n type diffusion layer 24, being exposed onto the interlayer insulating film 22. The n type diffusion layer 24 and n type polysilicon layer 26 are electrically connected together, constituting a storage node electrode of a capacitor. A dielectric film 28, which will be a dielectric of the capacitor, is formed on the n type polysilicon layer 26. Further, a cell plate electrode 30 comprising n type polysilicon, for example, is formed all over the dielectric film 28 and interlayer insulating film 22.

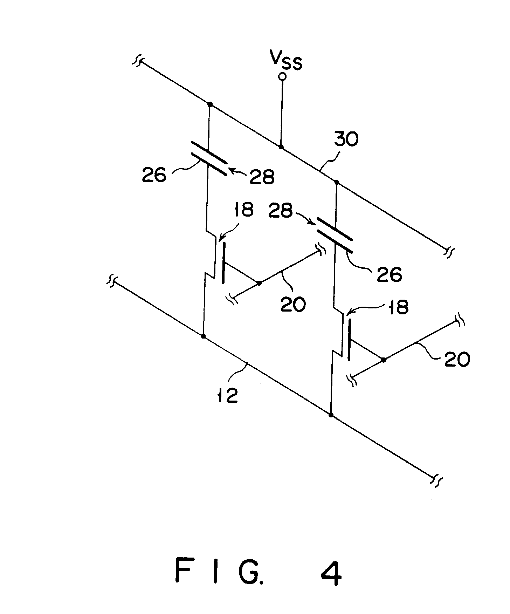

Fig. 4 illustrates an equivalent circuit of the DRAM cells having the above structure. The same reference numerals as used in Figs. 1 to 3 are used in Fig. 4 to denote the identical portions to avoid their otherwise redundant description.

According to the thus constituted DRAM cell, a capacitor is formed at the cross point between the word line (n type polysilicon layer 20) and the bit line (n type semiconductor layer 12). Further, a switching transistor forms a channel along the side of the columnar region 16 and perpendicular to the substrate 10. The structure of the DRAM cell is therefore suitable for high integration. In addition, the cell plate electrode 30 is formed on the entire surface of the substrate 10, thus providing the largest capacitance from the planar point of view.

According to the memory cell embodying the present invention, the insulating film 11 is formed between the p type substrate 10 and the n type semiconductor layer 12 which constitutes the bit line. This structure can reduce the capacitance of the bit line and decrease the junction leak current from the bit line to the substrate. As around the n type semiconductor layer 12 or the bit line is surrounded by the insulating film 11 and interlayer insulating film 22, the probability of α rays or the like entering the bit line or the probability of catching the carriers ionized by the a rays or the like can be reduced.

Each of the bit lines if formed of an N-type silicon layer, and is insulated not by an P-N junction, but by an insulation layer. There are no P-N junctions through which a leakage current may flow. Hence, the bit lines can be arranged at relatively short intervals, thereby increasing the integration density of the memory-cell array.

The N-type silicon layer connected to the storage node of each memory cell is insulated by an insulation layer, too. There are formed no P-N junctions through which a leakage current may flow. This also helps to increase the integration density of the memory-cell array.

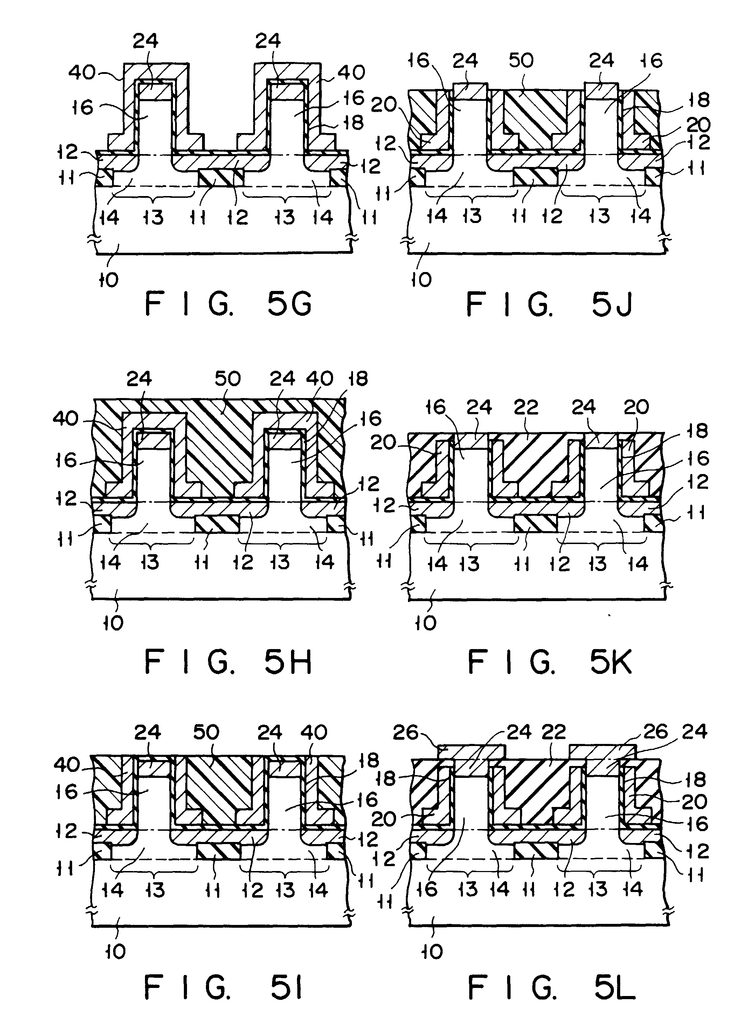

A method of fabricating a DRAM cell according to the first embodiment will be described below referring to Figs. 5A to 5L. The same reference numerals as used in Figs. 1 to 3 are used in Figs. 5A-5L to specify the identical portions to avoid their redundant description.

As shown in Fig. 5A, the thermal oxide film 11 is formed about 500 nm on the p type silicon substrate having, for example, a (100) face as the main surface by a LOCOS method, for example.

The thermal oxide film 11 is not restricted to this type, but may be a CVD silicon oxide film or a silicon nitride film deposited using a CVD method. Alternately, the thermal oxide film 11 may be a silicon oxide film deposited using an LPD method, or may be a composite film comprising the mentioned films.

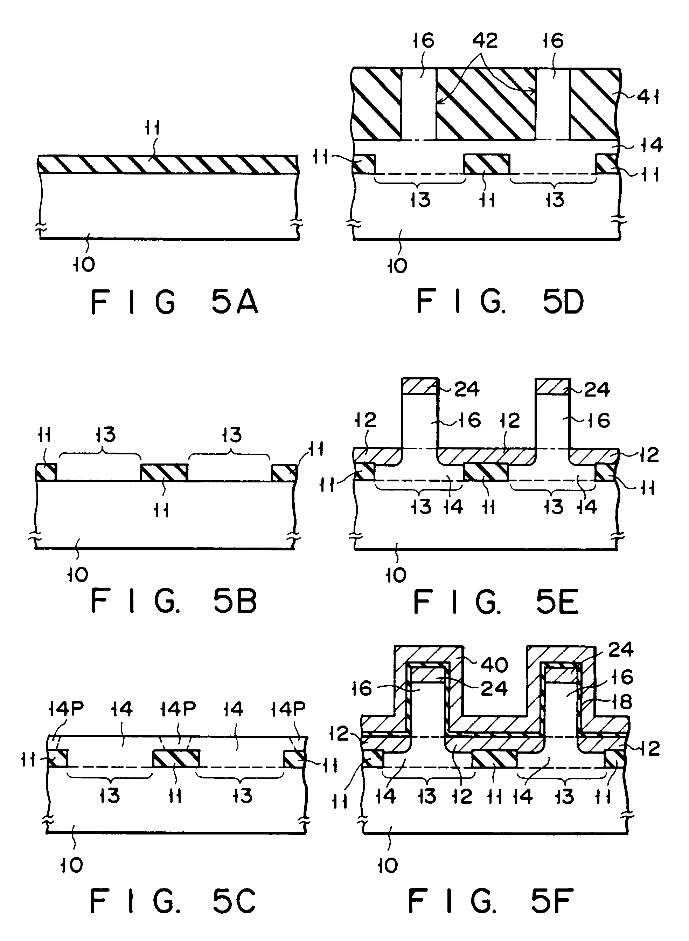

Then, the thermal oxide film 11 is selectively removed using, for example, an RIE method or anisotropic etching, as shown in Fig. 5B, thereby forming the openings 13 which reach the p type substrate 10.

The p type silicon epitaxial layer 14 is then grown in the openings 13, as shown in Fig. 5C, using a selective epitaxial growth technique (hereinafter referred to as "SEG"). As a result, the opening 13 is buried with the epitaxial layer 14. Then, the p type epitaxial layer 14 is deposited on the thermal oxide film 11 using non-selective epitaxial etching. At this time, the polysilicon layer 14P grows on the thermal oxide film 11, while the single-crystal silicon layer 14 having grown on the opening 13 continues to do so.

In further growing epitaxial silicon on the insulating film 11 after the epitaxial silicon is buried in the opening 13, the wafer which will be the substrate may temporarily be taken out from a furnace for the epitaxial growth process. Alternately, with the wafer left in the furnace, the epitaxial growth may continue while changing the conditions for growing the epitaxial silicon.

Although the epitaxial layer 14 to be grown on the p type substrate 10 may be of an n type as shown in Fig. 19, it is desirable that the layer 14 have the same conductivity type (p type) as the substrate 10 as in this embodiment. This structure can permit a columnar region (which will be formed later) or the channel forming region of the switching transistor to be electrically connected via the p type epitaxial layer 14 to the p type substrate 10. Consequently, the substrate potential of the p type substrate 10 can be applied as a back gate bias to the channel forming region of the switching transistor.

To provide the above structure, the epitaxial growth of silicon is conducted while mixing boron under this epitaxial growth atmosphere. Alternately, boron ions, for example, may be injected after the epitaxial grown is completed, or the boron ions, for example, may selectively be injected in that portion which is to be made p type, such as a portion where the columnar region is to be formed later. The same will be applied to the subsequent epitaxial growing process.

It is more preferable that the polysilicon layer 14P grown on the thermal oxide film 11 has been made single crystal using, for example, a laser beam annealing technique.

Then, the p type epitaxial layer 14 is patterned to be a bit line by performing a photo-etching method where necessary (not shown).

A silicon nitride film 41 is then deposited on the whole surface as shown in Fig. 5D, using a CVD method, for example. Then, an openings 42 are so formed using the photo-etching method as to reach the p type epitaxial layer 14 on the openings 13. Then, for example, p type silicon layers are selectively grown in the openings 42 using the SEG, thereby forming the p type columnar regions 16. The silicon nitride film 41 is not limited to this type, but it has only to be made of a material which has a large etching select ratio to the thermal oxide film 11 and can have high growth selectivity as well as high etching ratio to the growing material.

Then, as shown in Fig. 5E, the nitride film 41 is removed to expose the p type epitaxial layer 14 and p type columnar region 16. An n type impurity, for example, arsenic is ion-implanted in the exposed p type epitaxial layer 14 and the tip portion of the exposed p type columnar region 16. Then, the n type diffusion layer 12 constituting the bit line and the n type diffusion layer 24 constituting part of the storage node electrode are formed through thermal diffusion.

As shown in Fig. 5F, the gate insulating film 18 is then formed on the silicon surface exposed by the thermal oxidization. The conductive polysilicon layer 40 (either of n type or p type; the n type is desirable in view of the operational speed) is deposited on the resultant structure using the CVD method, for example.

As shown in Fig. 5G, the conductive polysilicon layer 40 is patterned into a word line pattern by the photo-etching method. This patterning is so conducted as to isolate the word line between the p type columnar regions 16.

After the photoresist (not shown) used in the step of Fig. 5G is removed, an organic film 50 comprising a resist, for example, is coated on the resultant structure, as shown in Fig. 5H.

Then, the organic film 50 and the conductive polysilicon layer 40 present at the tip portion of the p the columnar region 16 are etched back to expose the gate insulating film 18 by, for example, an RIE method or anisotropic etching, as shown in Fig. 5I.

Then, as shown in Fig. 5J, the gate insulating film 18 (e.g., silicon oxide film) and the conductive polysilicon layer 40 (20 in the diagram) are etched by, for example, a CDE method which is isotropic etching, thereby making the tip portion (around the n type diffusion layer 24) of the p type columnar region 16 protrude. The resultant structure can prevent the word line (conductive polysilicon layer) 20 from being short-circuited with the storage node electrode which will be formed later. The CDE method uses etching gas which can have a large etching select ratio of the silicon oxide film to silicon, for example, 1 : 10. Such etching gas may be of the Cl base ($CCl_4$ or the like) or Cl base + F base ($CCl_2F_2$ or the like).

Then, an interlayer insulating film 22 comprising a CVD silicon oxide film is deposited on the resultant structure, as shown in Fig. 5K using the CVD method, for example. The interlayer insulating film 22 is made flat and the n type diffusion layer 24 is exposed using the etch back technique which has been explained with reference to Figs. 5H and 5I.

An n type polysilicon layer is then formed on the resultant structure, as shown in Fig. 5L, using the CVD method, for example. Then, the n type polysilicon layer is patterned using the photo-etching method, thus forming the n type polysilicon layer 26 on the n type diffusion layer 24; the layer 26 will become part of the storage node electrode.

The n type polysilicon layer 26 is not limited to this type. For instance, with the n type diffusion layer 24 as a seed crystal, an n type epitaxial layer may be grown thereon to form the polysilicon layer 26. This method can permit the n type epitaxial layer corresponding to the n type polysilicon layer 26 to be self-aligned with the n type diffusion layer 24. Further, if the epitaxial growth is limited only to around the n type diffusion layer 24 and is controlled not to contact the other growth regions, the patterning of the n type polysilicon layer to provide the storage node electrode may be omitted.

The n type polysilicon layer 26 may be made of a high-melting point metal, such as tungsten or titanium, besides epitaxial silicon, or an alloy of such a high-melting point metal and silicon, namely, high-melting point metal silicide.

Then, as shown in Figs. 1 to 3, the dielectric film 28 of the capacitor, which comprises a silicon oxide film formed by, for example, thermal oxidization, is formed on the surface of the n type polysilicon layer 26.

The dielectric film 28 may be such a single-layered film as silicon nitride film, tantalum oxide film, yttrium oxide film or hafnium oxide film beside silicon oxide film, or a laminated film comprising these films.

Then, the cell plate electrode 30 comprising an n type polysilicon layer is formed using, for example, the CVD method. the cell plate electrode 30 may be made of a high-melting point metal, such as tungsten or titanium, besides epitaxial silicon, or an alloy of such a high-melting point metal and silicon (namely, high-melting point metal silicide) or aluminum or the like.

Through the above processes, the DRAM cell according to the present invention is completed.

Another method of fabricating a DRAM cell according to the first embodiment will now be described.

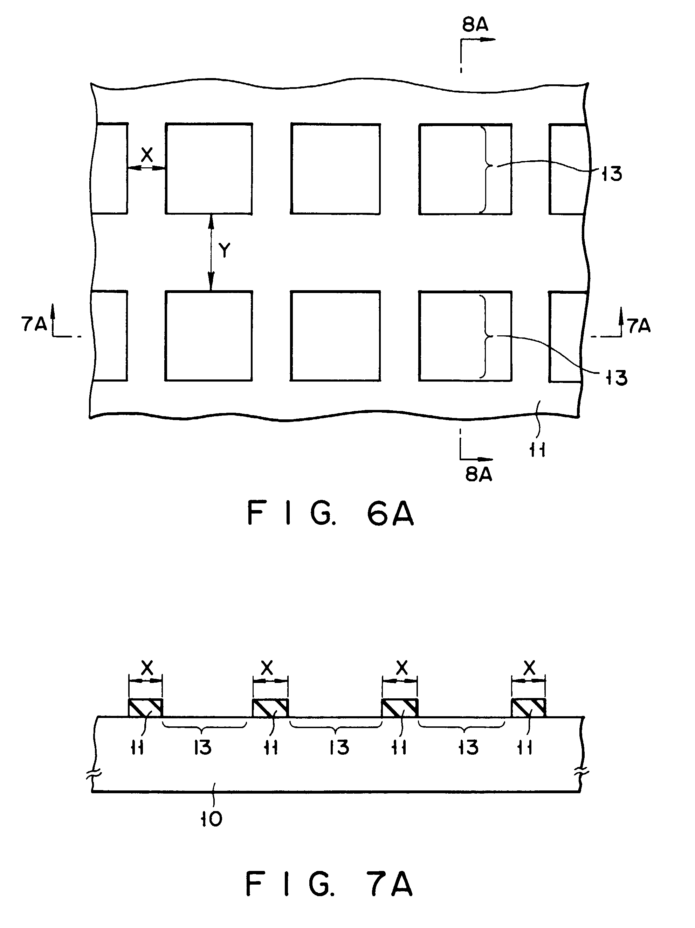

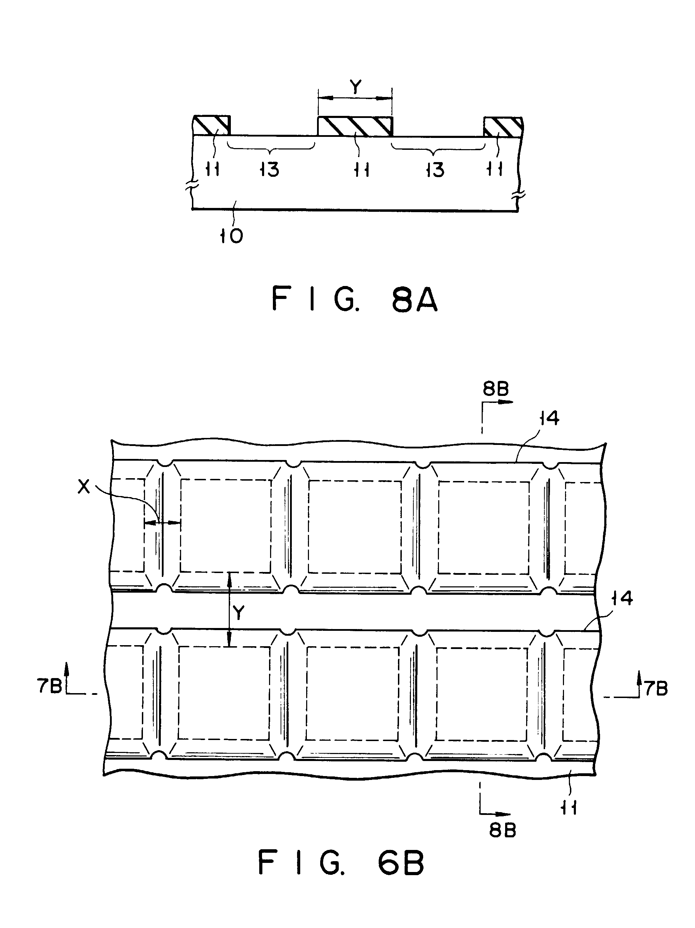

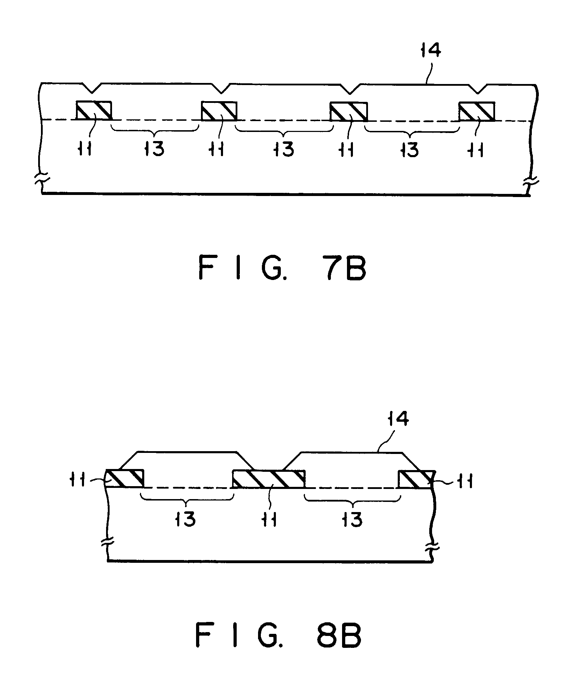

Figs. 6A and 6B are pattern plan views the step-by-step illustration of the first modification of the fabricating method. Fig. 7A is a cross section taken along the line 7A-7A in Fig. 6A, and Fig. 7B is a cross section taken along the line 7B-7B in Fig. 6B. Fig. 8A is a cross section taken along the line 8A-8A in Fig. 6A, and Fig. 8B is a cross section taken along the line 8B-8B in Fig. 6B. The same reference numerals as used in Figs. 1 to 3 are used in these diagrams to denote the identical portions to avoid their otherwise redundant description.

After the process shown in Fig. 5A, the openings 13 as shown in Figs. 6A, 7A and 8A are formed. At this time, the relation between the gap between these openings 13 in the bit-line forming direction X and the gap in the word-line forming direction Y is set to be

$$X < Y.$$

With this particular setting, the SEG is to be conducted.

If the epitaxial layers 14 are grown as shown in Figs. 6B, 7B and 8B, these layers 14 are connected together in the gap X, while the layers 14 are not connected in the gap Y. This is because the gap Y is greater than the gap X. Accordingly, the epitaxial layers 14 are so formed to be continuous in the bit-line forming direction and be discontinuous in the word-line forming direction. It is therefore possible to omit the bit-line patterning as described with reference to Fig. 5C, and form the bit line self-aligned with the opening 13.

The DRAM cell has only to be fabricated thereafter by the method explained with reference to Figs. 5D to 5L.

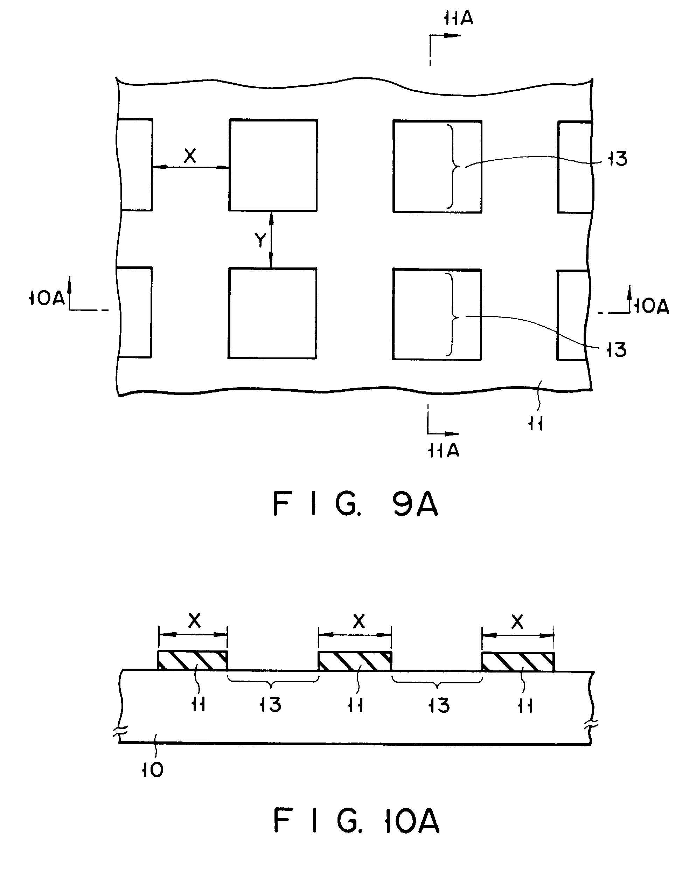

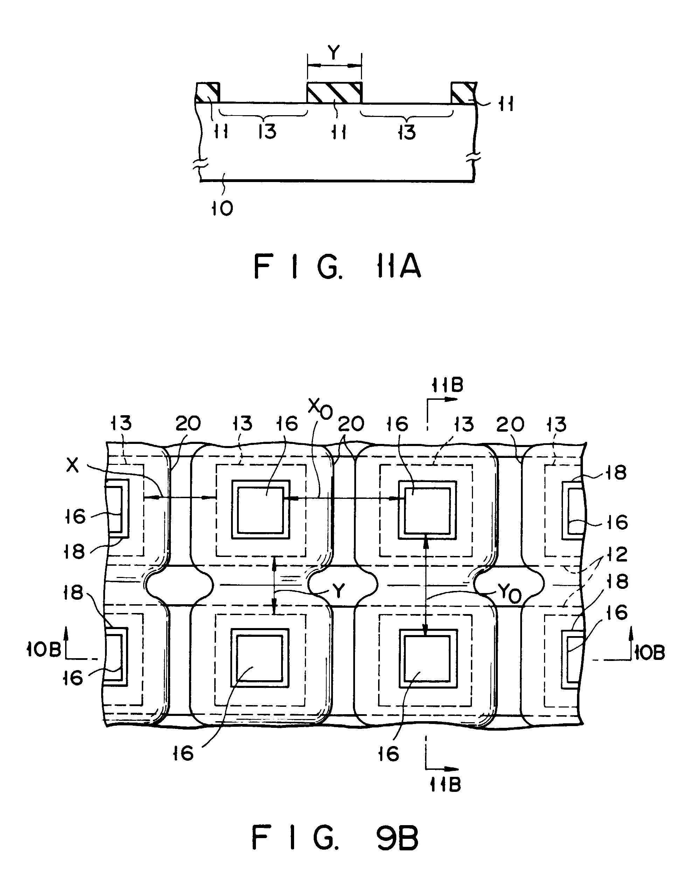

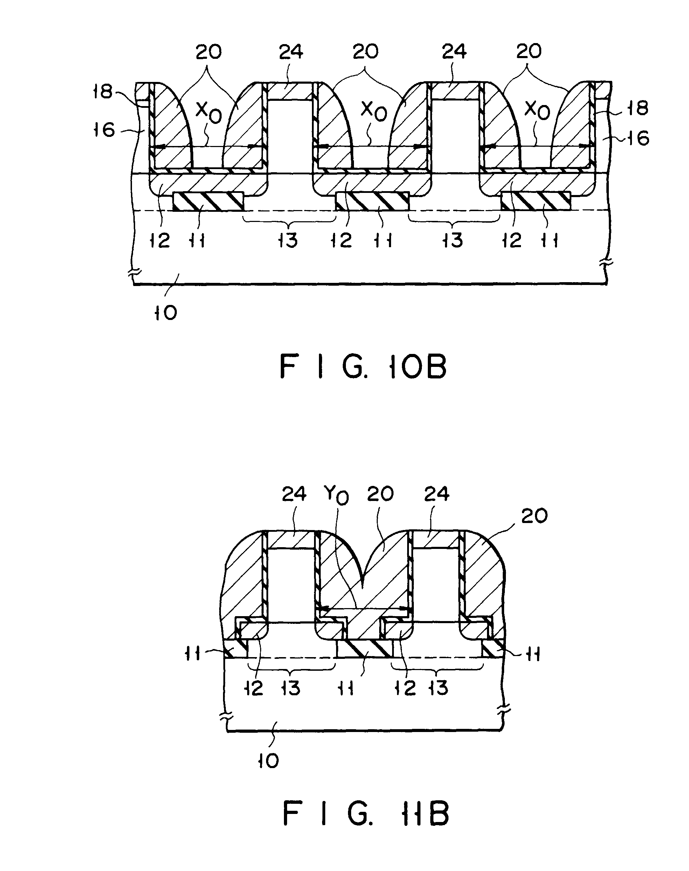

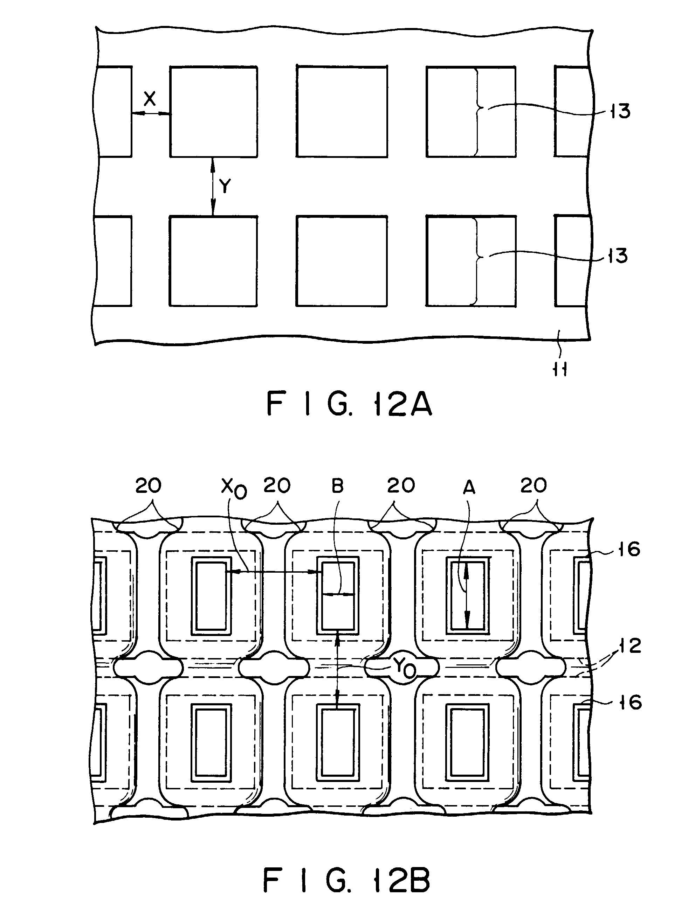

Figs. 9A and 9B are pattern plan views the step-by-step illustration of the second modification of the fabricating method. Fig. 10A is a cross section taken along the line 10A-10A in Fig. 9A, and Fig. 10B is a cross section taken along the line 10B-10B in Fig. 9B. Fig. 11A is a cross section taken along the line 11A-11A in Fig. 9A, and Fig. 11B is a cross section taken along the line 11B-11B in Fig. 9B. The same reference numerals as used in Figs. 1 to 3 are used in these diagrams to denote the identical portions to avoid their otherwise redundant description.

After the process shown in Fig. 5A, the openings 13 as shown in Figs. 9A, 10A and 11A are formed. At this time, the relation between the gap between these openings 13 in the bit-line forming direction X and the gap in the word-line forming direction Y is set to be

$$X > Y$$

which is reverse to the relation of the first modification. With this particular setting, the epitaxial layer 14 is grown by the method which has already been explained with reference to Fig. 5C, then the layer 14 is patterned to form the bit line 12. Then, the columnar region 16 is formed by the method described with reference to Fig. 5D, followed by the formation of the n type diffusion layers 12 and 24 by the method explained with reference to Fig. 5E.

Then, the polysilicon layer 20 to be the word line is deposited as shown in Figs. 9B, 10B and 11B. When the polysilicon layers 20 are etched using, for example, the RIE method, these layers 20 are isolated from each other in the gap X, while the layers 20 are connected together in the gap Y. In other words, the polysilicon layers 20 are so formed to be continuous in advance in the word-line forming direction and be discontinuous in the bit-line forming direction. It is therefore possible to omit the word-line patterning as described with reference to Fig. 5G, and form the word line (polysilicon layer 20) self-aligned with the columnar region 16.

The DRAM cell has only to be fabricated thereafter by the method explained with reference to Figs. 5H to 5L.

The patterning of the word line may be omitted by controlling the gap between the columnar regions 16 as well as controlling the gaps X and Y between the openings 13. That is, with $X_0$ denoting the gap between the columnar regions 16 in the bit-line forming direction and $Y_0$ being the gap in the word-line forming direction, the relation between these gaps is set as

$$X_0 > Y_0.$$

When anisotropic etching is conducted under this condition, the polysilicon layers are isolated from each other in the gap $X_0$ while they are connected in the gap $Y_0$. Therefore, the polysilicon layers 20 are so formed to be continuous in the word-line forming direction and be discontinuous in the bit-line forming direction.

Figs. 12A and 12B are pattern plan views the step-by-step illustration of the third modification of the fabricating method. The same reference numerals as used in Figs. 1 to 3 are used in these diagrams to denote the identical portions to avoid their otherwise redundant description.

After the process shown in Fig. 5A, the openings 13 as shown in Figs. 5A, 6A and 7A are formed. At this time, the gap X between these openings 13 in the bit-line forming direction is set to the value used in the first modification of the fabricating method and the gap Y in the word-line forming direction is set to the value used in the second modification of the fabricating method. Wit this setting, therefore, it is possible to omit the bit-line patterning and word-line patterning, and form the bit line self-aligned with the openings 13 as well as form the word line self-aligned with the columnar region 16, as shown in Fig. 5E.

According to the third modification of the fabricating method, it is desirable to control the arrangement and planar shape of the columnar regions 16.

For instance, the method of forming the bit line 12 without patterning is affected by the gap arrangement of the openings 13 as described in the section of the first modification.

The method of forming the word line 20 without patterning is affected by the gap arrangement of the columnar regions 16 as well as the gap arrangement of the openings 13 as explained in the section of the second modification.

Now in addition to the control of the gaps of the columnar regions 16 or the control of the gap $X_0$ in the bit-line forming direction and the gap $Y_0$ in the word-line forming direction, the planar shape of the columnar regions 16 is to be controlled. For instance, the planar shape of the columnar regions 16 is so set as to realize the relation

$$A > B$$

where A is the length of the columnar regions 16 in the word-line forming direction and B is the length in the bit-line forming direction. Setting this length relation can control the gap $X_0$ in the bit-line forming direction and the gap $Y_0$ in the word-line forming direction.

Although this control of the planar shape of the columnar regions 16 can also be applied to the second modification of the fabricating method, it is desirable to use such control particularly in the third modification which forms both the word line and bit line without any patterning.

The DRAM cell has only to be fabricated thereafter by the method explained with reference to Figs. 5H to 5L.

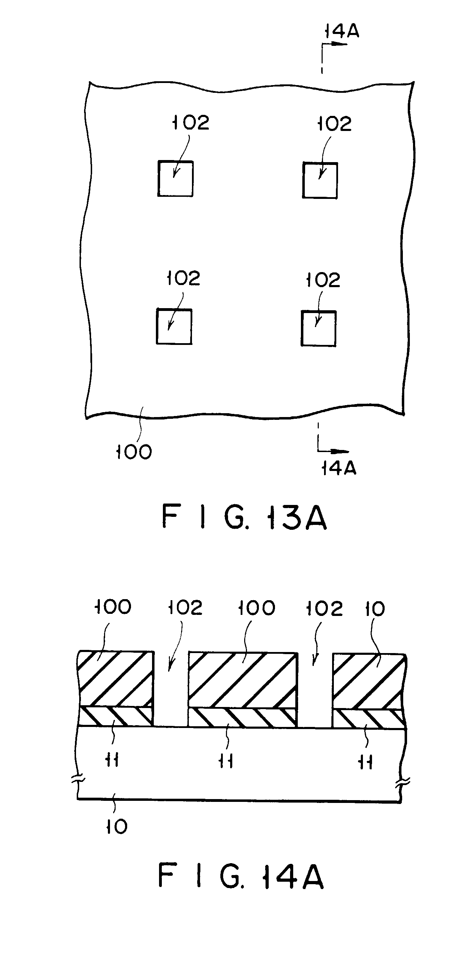

Figs. 13A to 13D are pattern plan views the step-by-step illustration of the fourth modification of the fabricating method. Figs. 14A through 14D are cross sections respectively taken along the lines 14A-14A to 14D-14D in Figs. 13A to 13D. The same reference numerals as used in Figs. 1 to 3 are used in these diagrams to specify the identical portions to avoid their otherwise redundant description.

After the process shown in Fig. 5A, an insulating film 100 comprising a silicon nitride film is deposited on the entire surface of the resultant structure as shown in Figs. 13A and 14A using, for example, the CVD method. Then, openings 102 are formed by the photoetching method, penetrating the silicon nitride film 100 and the insulating film 11 comprising a silicon oxide film and reaching the p type silicon substrate 10.

The insulating film 100 is not limited to a silicon nitride film, but it has only to be made of a material which has a large etching select ratio to the insulating film 11 (silicon oxide film in this embodiment) and has high growth ratio of the substrate 10 to silicon.

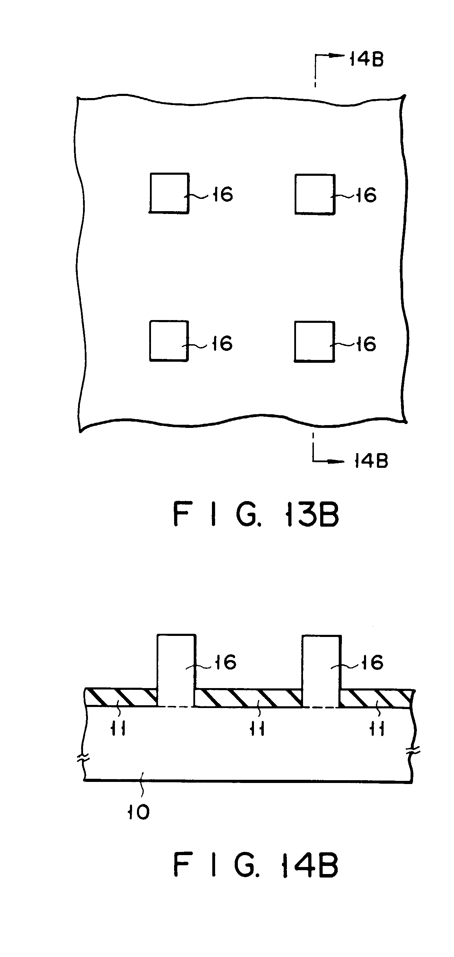

Then, epitaxial silicon is selectively grown in the opening 102 by the SEG, for example, as shown in Figs. 13B and 14B.

It is desirable that the epitaxial silicon to be selectively grown have the same conductivity type as the substrate 10.

The insulating film 100 is then removed.

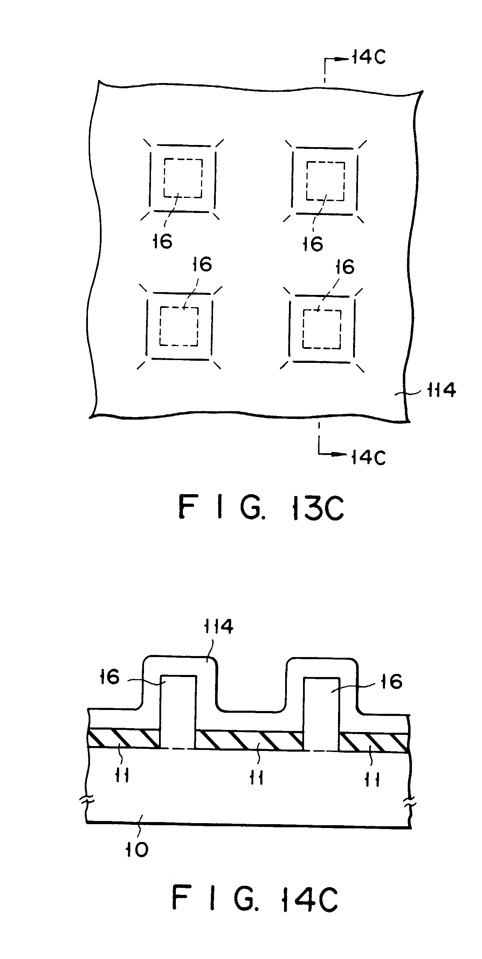

Then, as shown in Figs. 13C and 14C, an epitaxial silicon layer 114 is selectively formed on the resultant structure.

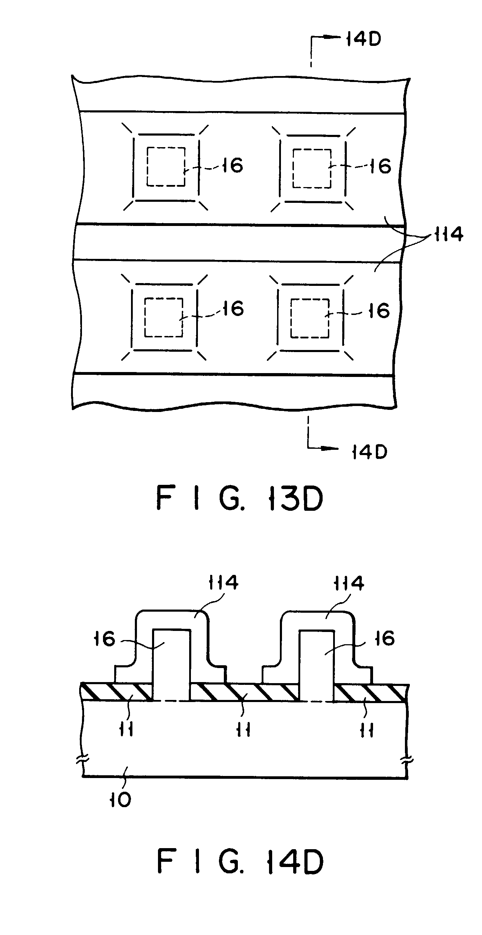

The epitaxial silicon layer 114 is then patterned to yield the bit line pattern as shown in Figs. 13D and 14D.

The silicon layer which constitutes the bit line may be formed after forming the columnar region 16 as described above.

The DRAM cell has only to be fabricated thereafter by the method explained with reference to Figs. 5E to 5L.

The effects of the DRAM cells according to the first embodiment will be explained below referring to specific values.

When the isolation between the bit line formed by a diffusion layer and substrate as in the conventional cell is pn junction, with

impurity density of the substrate: about $1 \times 10^{17}$ $cm^{-3}$

impurity density of the bit line: about $1 \times 1020$ $cm^{-3}$

then the capacitance of the pn junction is about 0.4 ($fF/\mu m^2$) per unit area (f: "femto" which is the prefix to indicate $10^{-15}$).

This capacitance is equivalent to the film thickness of 86.3 nm of the capacitor insulating film (assumed to be $SiO_2$) in terms of the MOS capacitance. If the thickness of the insulating film is 86.3 nm or greater, for example, 500 nm mentioned above, it is understood that the bit line capacitance significantly decreases. Accordingly, the speed of an electrical signal running through the bit line is improved.

It is also known that the signal potential read on the bit line is proportional to $C_S/C_B$ where $C_S$ is the memory cell capacitance and $C_B$ is the bit line capacitance. According to the cell of present invention, particularly $C_B$ can be made smaller, increasing the signal potential and stabilizing the circuit operation as a consequence. Further, even if $C_S$ is made smaller than the conventional one, it is possible to acquire a sufficiently large signal potential. The allowance for smaller $C_S$ means that the load in the fabricating processes can be reduced. For instance, various propositions have been made so far to sufficiently increase the signal potential, paying great attention to increasing $C_S$. This requires that the dielectric film of the cell capacitor be made thinner, a ferroelectric film be used or these films be laminated, resulting in a very large load in the fabricating processes. In other words, the formation of such a ferroelectric film increases the number of steps required for the cell fabrication, or is difficult to achieve due to the today's insufficient state-of-the-art.

According to the present invention, however, the DRAM cell is designed also in light of reduction in $C_B$, so that a sufficiently large signal potential can be obtained even by the present state-of-the-art, e.g., forming the dielectric film of a single-crystal silicon oxide film having a thickness of about 10 nm. In addition, the art of forming such a dielectric film is now fully established, realizing high yield in the fabrication of the DRAM cells.

Of course, the mentioned measure of making the dielectric film thinner, using a ferroelectric film or lamination of these films can also be applied to the fabrication of the DRAM cells according to the present invention without causing any problem. Such a measure, if applied to this invention, can realize the demand of higher integration.

Further, the conventional memory cell has a problem of a large leak current from the bit line to the substrate. This current is called a pn junction reverse current which is originated from crystal defect caused in the substrate where a depletion layer is to be formed. The crystal defect will surely occur due to variation in the fabricating processes or the like. The generation of the leak current reduces the potential of the signal to be read out.

Since, according to the semiconductor memory device embodying the present invention, the bit line is isolated as much as possible from the substrate by the insulating film, so that the pn junction between the bit line and substrate can be limited only to the vicinity of the region where the source or drain of the switching transistor is formed, thus reducing the leak current.

The conventional memory cell also has a problem of generating a soft error.

The soft error will originate from the wiring layer made of aluminum or the like in the memory device, or α rays or the like, generating and emanated from the package containing the device, hitting the pn junction, when cell data is read out from the bit line. The α rays travel through the silicon substrate while generating pairs of electrons and holes. In particular, the generated electrons enter the bit line along the diffusion or the locus of the α rays, changing (lowering) the potential of the bit line. When the amount of reduction is greater than the signal potential to be read out, a so-called erroneous reading (soft error) would occur. The larger the pn junction area between the bit line and substrate, the higher the probability of occurrence of the soft error.

According to the memory cell of the present invention, however, the pn junction between the bit line and the substrate is avoided as much as possible, thus dropping the probability of causing the soft error. In other words, the insulating film formed between the bit line and substrate becomes a barrier to shield the electrons generated by incident α rays.

The effects originating from modification of the fabricating method will now be discussed.

The effect on the structure of the memory cell according to the first modification is such that the bit line is formed in self-alignment with the opening formed in the insulating film which isolates the bit line from the substrate, realizing a finer bit line pattern.

The effect on the fabricating method is to be able to omit a step of patterning the bit line to thereby suppress an increase in the number of required steps.

The effect on the structure of the memory cell according to the second modification is such that the word line is formed in self-alignment with the columnar region formed on the aforementioned opening, realizing a finer word line pattern.

The effect on the fabricating method is to be able to omit a step of patterning the word line to thereby suppress an increase in the number of required steps.

The effect on the structure of the memory cell according to the third modification is the combination of the effects obtained by the first and second modifications.

The effect on the fabricating method is to be able to omit a step of patterning the bit line to thereby suppress an increase in the number of required steps.

The effect on the structure of the memory cell according to the fourth modification is such that the columnar region which should communicate with the substrate is formed in self-alignment with the aforementioned opening formed in the insulating film, so that the columnar region is suitable to realize higher integration of DRAM cells. In this case, the memory cells will have the smallest pn junction area between the bit line and substrate.

The effect of the fourth modification on the fabricating method is such that the patterning of a mask (insulating film) to form the columnar region and the patterning of the opening in the insulating film, which reaches the substrate, can be done in a single step, thus suppressing an increase in the number of required steps.

The present invention is not restricted to the above-described embodiments, but may be modified in various manners without departing from the scope of the claims.

Reference signs in the claims are intended for better understanding and shall not limit the scope.

## Claims

1. A method of fabricating a semiconductor memory device comprising the steps of:

   preparing a semiconductor substrate (10) of a first conductivity type;
   forming an insulating film (11) on said substrate (10) so as to have a plurality of openings (13) arranged in a matrix manner from an overhead planar view;
   forming a plurality of line-like semiconductor layers (14) on said insulating film (11) so as to be in contact with said substrate (10) through said openings (13);
   forming a plurality of semiconductor pillar regions (16) of the first conductivity-type on those portions which face said openings (13) of said plurality of line-like semiconductor layers (14);
   forming a plurality of first semiconductor layers (24) of the second conductivity type in upper portions of said pillar regions (16), and a plurality of second semiconductor layers (12) of the second conductivity type in portions having exposed surfaces of said line-like semiconductor layers (14);
   forming a plurality of gate electrodes (20) on side walls of said pillar regions (16) ;
   forming an interlayer insulating film (22) having parts extending to the first semiconductor layers (24);
   forming a plurality of storage node electrodes (26) on and electrically connected to said first semiconductor layers (24);
   forming a plurality of dielectric layers (28) on said storage node electrode (26) ; and
   forming a plurality of plate electrodes (30) capacitivly coupled with said storage node electrodes (26) via said dielectric layers (28); wherein
   said parts of said interlayer insulating film (22) extending to said first semiconductor layer (24) are formed by filling up a space including higher and lower parts on a surface of said substrate (10) with said interlayer insulating film (22), etching back said interlayer insulating film (22) , and exposing top surfaces of said first semiconductor layers (24) ; and characterised in that said storage node electrodes (26) are formed on and electrically connected to the top surfaces of said first semiconductor layers (24) exposed from the surfaces of said interlayer insulating film (22), and overlapping on said interlayer insulating film (22), and in that first and second different intervals (X, Y) for said plurality of openings (13) in said insulating film (11) are determined such that the openings are spaced apart in a row direction of said matrix by the first interval (X) and in a column direction of said matrix by the second interval (Y), the first interval (X) being narrower that the second interval (Y), said line-like semiconductor layers (14) being formed in only the row direction by epitaxial growth of the line-like semiconductor layers such that the growth closes the first narrower interval between openings (13) to form line-like semiconductor layers (14) without a lithography step.

2. A method of fabricating the semiconductor memory device according to claim 1, characterised in that third and fourth different intervals (XO, YO) for said pillar regions (16) are determined in terms of said row direction and said column direction and said gate electrodes (20) are linked to one another in only the column direction with respect to the narrower interval (YO) of the third and fourth intervals by deposition and reactive ion etching of a conductive film (40) such that side walls of the conductive film remaining after RIE close the narrower interval between said pillar regions (16) to form a word line without a lithography step.

## Patentansprüche

1. Verfahren zur Herstellung einer Halbleiterspeichereinrichtung mit den Schritten:

   Vorbereiten eines Halbleitersubstrates (10) eines ersten Leitfähigkeitstyps;

   Bilden einer Isolierschicht (11) auf diesem Substrat (10) derart, daß sie eine Vielzahl von Öffnungen (13) aufweist, die in der Draufsicht in Matrixform angeordnet sind;

   Bilden einer Vielzahl linienartiger Halbleiterschichten (14) auf der Isolierschicht (11) derart, daß sie durch die Öffnungen (13) Kontakt mit dem Substrat (10) haben;

   Bilden einer Vielzahl von Halbleiter-Säulenbereichen (16) des ersten Leitfähigkeitstyps auf denjenigen Bereichen der Vielzahl linienartiger Halbleiterschichten (14), welche die Öffnungen (13) abdecken;

   Bilden einer Vielzahl erster Halbleiterschichten (24) des zweiten Leitfähigkeitstyps im oberen Teil der Säulenbereiche (16) sowie einer Vielzahl zweiter Halbleiterschichten (12) des zweiten Leitfähigkeitstyps in Bereichen, welche freiliegende Oberflächen der linienartigen Halbleiterschichten (14) aufweisen;

Bilden einer Vielzahl von Gate-Elektroden (20) an den Seitenwänden der Säulenbereiche (16);

Bilden einer Isolierzwischenschicht (22) mit Teilen, die sich zu den ersten Halbleiterschichten (24) erstrecken;

Bilden einer Vielzahl von Speicherknoten-Elektroden (26) auf und elektrisch verbunden mit den ersten Halbleiterschichten (24);

Bilden einer Vielzahl dielektrischer Schichten (28) auf den Speicherknoten-Elektroden (26); und

Bilden einer Vielzahl von Plattenelektroden (30), welche über die dielektrischen Schichten (28) kapazitiv mit den Speicherknoten-Elektroden (26) gekoppelt sind; wobei

die sich zur ersten Halbleiterschicht (24) erstreckenden Teile der Isolierzwischenschicht (22) durch Auffüllen eines Raumes, der höhere und niedrigere Bereiche auf der Oberfläche des Substrats (10) umfaßt, mit der Isolierzwischenschicht (22), Abätzen der Isolierzwischenschicht (22) und Freilegen der Oberseiten der ersten Halbleiterschichten (24) gebildet werden, dadurch gekennzeichnet, daß

die Speicherknoten-Elektroden (26) auf den von der Isolierzwischenschicht (22) befreiten Oberseiten der ersten Halbleiterschicht (22) gebildet und mit diesen elektrisch verbunden werden sowie diese Isolierzwischenschicht (22) überlappen und weiterhin dadurch, daß unterschiedliche erste und zweite Abstände (X, Y) zwischen der Vielzahl der Öffnungen (13) derart festgelegt werden, daß die Öffnungen in Zeilenrichtung der Matrix in einem ersten Abstand (X) und in Spaltenrichtung der Matrix in einem zweiten Abstand (Y) angeordnet sind und der erste Abstand (X) kleiner ist als der zweite Abstand (Y) sowie die linienartigen Halbleiterschichten (14) ausschließlich durch epitaktisches Wachstum derselben in Zeilenrichtung gebildet werden, so daß die ersten, kleineren, durch dieses Wachstum geschlossenen Abstände zwischen den Öffnungen (13) ohne Anwendung eines Lithographie-Schrittes die linienartigen Halbleiterschichten (14) ergeben.

2. Verfahren zur Herstellung einer Halbleiterspeichereinrichtung nach Anspruch 1, dadurch gekennzeichnet, daß bezüglich der Zeilenrichtung und der Spaltenrichtung unterschiedliche dritte und vierte Abstände ($X_0$, $Y_0$) zwischen den Säulenbereichen (16) festgelegt und die Gate-Elektroden (20) wegen des kleineren Abstandes ($Y_0$) von den beiden dritten und vierten Abständen durch Abscheidung einer leitfähigen Schicht (40) und reaktives Ionenätzen (RIE) derselben derart, daß die Seitenwände der nach dem reaktiven Ionenätzen zurückbleibenden leitfähigen Schicht die kleineren Abstände zwischen den Säulenbereichen (16) schließt, untereinander nur in Spaltenrichtung verbunden werden, um ohne Anwendung eines Lithographie-Schrittes eine Wortleitung zu bilden.

## Revendications

1. Procédé de fabrication d'un dispositif de mémoire à semi-conducteur, comprenant les étapes suivantes :

la préparation d'un substrat semi-conducteur (10) d'un premier type de conductivité,
la formation d'un film isolant (11) sur le substrat (10) afin que plusieurs ouvertures (13) soient placées sous forme d'une matrice en vue en plan,
la formation de plusieurs couches semi-conductrices (14) en forme de lignes sur le film isolant (11) afin qu'elles soient au contact du substrat (10) par les ouvertures (13),
la formation de plusieurs régions de colonnes semi-conductrices (16) du premier type de conductivité sur les parties tournées vers les ouvertures (13) des couches semi-conductrices (14) en forme de lignes,
la formation de plusieurs premières couches semi-conductrices (24) du second type de conductivité sur des parties supérieures des régions de colonnes (16), et de plusieurs secondes couches semi-conductrices (12) du second type de conductivité dans des parties ayant des surfaces exposées des couches semi-conductrices (14) en forme de lignes,
la formation de plusieurs électrodes de grille (20) sur des parois latérales des régions de colonnes (16),
la formation d'un film isolant (22) entre les couches, ayant des parties s'étendant vers les premières couches semi-conductrices (24),
la formation de plusieurs électrodes (26) de noeud de mémorisation sur les premières couches semi-conductrices (24) et connectées électriquement à ces couches,
la formation de plusieurs couches diélectriques (28) sur l'électrode (26) de noeud de mémorisation, et

la formation de plusieurs électrodes (30) de plaque couplées capacitivement aux électrodes (26) de noeud de mémorisation par les couches diélectriques (28), dans lequel

lesdites parties du film isolant (22) entre les couches s'étendant vers la première couche semi-conductrice (24) sont formées par remplissage d'un espace comprenant des parties relativement hautes et relativement basses sur une surface du substrat (10) par le film isolant (22) placé entre les couches, par attaque à nouveau du film isolant (22) placé entre les couches et par exposition des surfaces supérieures des premières couches semi-conductrices (24), et caractérisé en que :

les électrodes (26) de noeud de mémorisation sont formées sur les surfaces supérieures et sont connectées électriquement à ces surfaces supérieures des premières couches semi-conductrices (24) exposées à partir des surfaces du film isolant (22) placé entre les couches, avec recouvrement sur le film isolant (22) placé entre les couches, et en ce que des premiers et seconds intervalles différents (X, Y) pour les ouvertures (13) dans le film isolant (11) sont déterminés de manière que les ouvertures soient séparées dans une direction des lignes de la matrice par un premier intervalle (X) et dans une direction des colonnes de la matrice par le second intervalle (Y), le premier intervalle (X) étant inférieur au second intervalle (y), les couches semi-conductrices (14) en forme de lignes étant formées uniquement dans la région des lignes de la matrice par croissance épitaxiale des couches semi-conductrices en forme de lignes de manière que la croissance ferme le premier intervalle relativement étroit entre les ouvertures (13) pour la formation des couches semi-conductrices (14) en forme de lignes sans étape lithographique.

2. Procédé de fabrication du dispositif de mémoire à semi-conducteur selon la revendication 1, caractérisé en ce qu'un troisième et un quatrième intervalle différents $(X_0, Y_0)$ des régions de colonnes (16) sont déterminés dans la direction de lignes et dans la direction de colonnes de la matrice, et les électrodes de grille (20) sont reliées mutuellement uniquement dans la direction des colonnes par rapport à l'intervalle relativement étroit $(X_0)$ du troisième et du quatrième intervalle par dépôt d'un film conducteur (40) et attaque par des ions réactifs de ce film afin que les parois latérales du film conducteur restant après l'attaque RIE ferment l'intervalle relativement étroit entre les régions de colonnes (16) pour la formation d'une ligne de mot sans étape lithographique.

F I G. 1

F I G. 2

F I G. 3

F I G.  4

F I G   5A

F I G.   5D

F I G.   5B

F I G.   5E

F I G.   5C

F I G.   5F

F I G. 5G

F I G. 5J

F I G. 5H

F I G. 5K

F I G. 5I

F I G. 5L

FIG. 6A

FIG. 7A

F I G. 8A

F I G. 6B

16

F I G. 7B

F I G. 8B

FIG. 9A

FIG. 10A

FIG. 11A

FIG. 9B

F I G. 10B

F I G. 11B

F I G. 12A

F I G. 12B

14A

102 102

102 102

100

14A

F I G. 13A

100 102 100 102 10

11 11 11

10

F I G. 14A

F I G. 13B

F I G. 14B

14C

16       16

16       16

114

14C

# F I G. 13C

114

16       16

11     11     11

10

# F I G. 14C

F I G. 13D

F I G. 14D